(19) Europäisches Patentamt
European Patent Office
Office européen des brevets

(11) Publication number: **0 074 807**
**A1**

(12) # EUROPEAN PATENT APPLICATION

(21) Application number: 82304754.3

(22) Date of filing: 09.09.82

(51) Int. Cl.³: G 02 F 1/01
C 09 K 11/06, C 09 B 57/10
G 02 F 1/133, H 01 L 31/00
H 01 S 3/20

(30) Priority: 10.09.81 GB 8127334

(43) Date of publication of application:
23.03.83 Bulletin 83/12

(84) Designated Contracting States:
DE FR GB NL

(71) Applicant: The Secretary of State for Defence in Her Britannic Majesty's Government of The United Kingdom of Great Britain and Northern Ireland Whitehall
London SW1A 2HB(GB)

(72) Inventor: Cook, Michael John
8 Nutfield Close
Norwich Norfolk NR4 6PF(GB)

(72) Inventor: Lewis, Anthony Peter
27 Abinger Way
Norwich Norfolk(GB)

(72) Inventor: McAuliffe, Glenn Stuart Gibson
Flat K, Peartree Court 329 Upper Richmond Road
Putney London SW15(GB)

(72) Inventor: Skarda, Vladimir
107 Bull Close Road
Norwich Norfolk NR3 1NY(GB)

(72) Inventor: Thomson, Andrew James
12 Armitage Close
Cringleford Norwich Norfolk(GB)

(72) Inventor: Glasper, John Lewis
Eastlea Homend Crescent
Ledbury Herefordshire(GB)

(72) Inventor: Robbins, David John
2 Mark Close
Malvern Worcestershire(GB)

(74) Representative: McCormack, Derek James et al,
Procurement Executive Ministry of Defence Patents
1A(4) Room 2014 Empress State Building Lillie Road
London SW6 1TR(GB)

(54) **Fluorescent optical concentrator devices.**

(57) An optical concentrator device includes a radiation receiving area, a radiation emitting area, two spaced reflecting surfaces and between the reflecting surfaces a host material incorporating within it a fluorescent dye, wherein the dye comprises a complex of the formula $ML_6Z$, where: M represents a metal selected from Ru(II), Os(II) and Ir(III); $L_6$ represents a plurality of ligands satisfying six valencies of M, at least one of which ligands is provided by a heterocyclic organic molecule containing at least one non-metal atom capable of ligand-bonding to the metal M; and Z represents one or more ions associated with $ML_6$, Z being present when $ML_6$ carries an overall ionic charge and absent when $ML_6$ carries no overall ionic charge, Z having an overall ionic charge equal and opposite to the overall ionic charge of $ML_6$.

The device may be a solar collector device, a fluorescent light activated display (FLAD) or a dye laser.

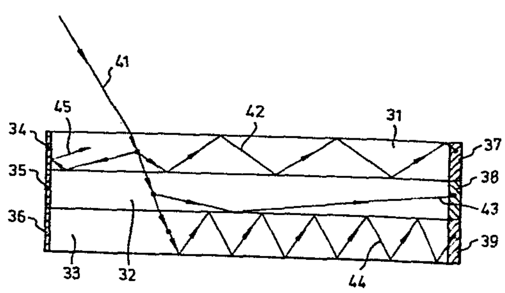


Fig. 6.

EP 0 074 807 A1

The present invention relates to fluorescent optical concentrator devices.

Fluorescent optical concentrator devices are a series of devices which have the following common features. A fluorescent dye is dissolved in a host material, eg glass or plastics. Radiation incident on the host material, eg ambient light or light from an adjacent generator, is absorbed in the host material by the dye. Light is re-emitted by the dye which, in terms of its intensity versus wavelength curve, is characteristic of the particular dye used. The re-emitted light is subject to internal reflection within the host material at the surfaces of the host material. A light outlet is provided at a particular surface of the host material or a surface adjacent thereto, so that the internally reflected light re-emitted by the dye is allowed to leave the host material primarily at the light outlet. Thus, radiation incident on the device is collected, re-emitted as light and concentrated by the surfaces of the device to re-emerge from a particular light outlet.

Examples of applications of known fluorescent optical concentrator devices are as follows.

1 Fluorescent light activated displays (FLADs)

Devices of this kind are described in USA patent specification numbers 4,142,781 and 4,111,534. The concentrator device is located behind a conventional light modulating display, eg a liquid crystal display. Ambient light is incident on the host material of the concentrator device via the light modulating display. The light outlet of the concentrator device is in the form of a series of regions, eg the bars of an alphanumeric digit, provided on a surface of the concentrator device which is generally parallel to the operating electrodes of the light modulating display. These regions correspond in shape and position within the plane that they are contained to the shape and position of the electrodes.

These regions comprise rough, eg specially scratched, portions which do not permit total internal reflection. Light from the concentrator device is re-transmitted through the display. The concentrator device improves the observed contrast of the display.

2 Planar solar collectors (PSCs)

Devices of this kind are described for example in the following references:

(i) Applied Optics 15 2299 (1976) - W H Weber and J Lambe;

(ii) Optics Letters 1 73 (1977) - B A Swartz, T Cole and A H Zewail;

(iii) Applied Physics 14 123 (1977) - A Goetzberger and W Greubel;

(iv) US Patent No 4,260,219.

The host material is in the form of at least one planar rectangular plate. Ambient radiation incident on the or each plate is absorbed and re-emitted by the dye and this re-emitted light is guided by internal reflection along the plate to an outlet surface where the light is coupled into a solar cell. This may be either at the edge of the plate or adjacent to a surface thereof.

3 Dye lasers

In these the host material containing the dye is contained or flows between two facing mirror surfaces. The first of these two surfaces provides total internal reflection. The second provides almost but not total internal reflection. The host material is excited with radiation from an adjacent source. The radiation is absorbed by the dye and re-emitted as light which is internally reflected between the mirror surfaces. This light eventually emerges through the second mirror surface which acts as the light outlet. The emergent light is coherent laser light (because it consists of photons whose emission is stimulated by other photons from the dye molecules during the internal reflection process). Optionally, the light output may be controlled to be in the form of a series of pulses by controlling the reflection of the second mirror surface with a known Q-switch.

The fluorescent dyes which have previously been considered for use in fluorescent optical concentrator devices, eg rhodamines, are not ideal largely because of limited spectral absorption of ambient radiation (particularly in the case of FLADs and PSCs) and strong self-absorption of the re-emitted light.

In US Patent No 4,260,219 a method of reducing self-absorption is proposed which involves incorporating as a colloidal solution in a solid host material an amphiphilic additive to enclose fluorescent dye particles therein within a colloidal droplet of the additive. The additive is proposed to provide an orientation polarisation to enable a shift of the emission spectrum relative to the absorption spectrum of the dye to take place. The potential disadvantages of this method are that the introduction of the additive increases the cost of production, the additive/dye concentration has to be carefully controlled and the method is only feasible with a very limited number of dyes. In fact no examples of suitable dyes are mentioned in the patent.

It is an object of the invention to provide a fluorescent optical concentrator device incorporating a fluorescent dye having better absorption of ambient radiation (particularly in the case of FLADs and PSCs) and less self-absorption than the dyes previously considered for use in fluorescent optical concentrator devices.

According to the present invention an optical concentrator device includes a radiation receiving area, a radiation emitting area, two spaced reflecting surfaces and between the reflecting surfaces a host material incorporating within it a fluorescent dye, wherein the dye comprises a complex of the formula $ML_6Z$, where: M represents a metal selected from Ru(II), Os(II) and Ir(III); $L_6$ represents a plurality of ligands satisfying six valencies of M, at least one of which ligands is provided by a heterocyclic organic molecule containing at least one non-metal atom capable of ligand-bonding to the metal M; and Z represents one or more ions associated with $ML_6$, Z being present when $ML_6$ carries an overall ionic charge and absent when $ML_6$ carries no overall ionic charge, Z having an overall ionic charge equal and opposite to the overall ionic charge of $ML_6$.

The ligands L in the Formula $ML_6Z$ may be mono-dentate ligands or part of a poly-dentate ligand structure which may contain the same or different ligands.

Preferably, the said non-metal is provided by a heterocyclic aromatic molecule. It is preferably nitrogen, although it may also be oxygen, sulphur or phosphorus.

Preferably, at least two of the ligands L are contained in bidentate ligand structures, a single heterocyclic molecule,preferably aromatic, providing both of such ligands. Preferably one, desirably each, of the bonds to the metal M is provided by nitrogen.

Preferably, at least four of the ligands L are provided by two heterocyclic molecules each containing (at least) two nitrogen atoms all four of the nitrogen atoms being ligand-bonded to the metal M. Desirably the two heterocyclic molecules are identical aromatic molecules.

Where M is Ru(II) or Os(II) all of the ligands L are preferably provided by bidentate structures containing nitrogen in an overall structure as shown in Formula (Ia) as follows:

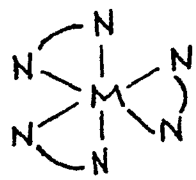

Formula Ia

where 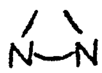 represents a pair of the ligands formed by a single heterocyclic molecule which is a double nitrogen containing heterocyclic chelating agent. Preferably, at least two of the three heterocyclic molecules are identical and they are desirably aromatic.

Where M is Ir(III) it is preferred that of the six ligands L four are provided by heterocyclic molecules, which are preferably identical and aromatic, each of which is a double nitrogen containing heterocyclic chelating agent and two are provided by halogens eg Cl. The complex structure may be in a cis-configuration in this form.

In any of the above classes of complex where one or more pairs of the ligands L in the formula $ML_6Z$ are contained in bidentate ligand structures they may be provided by a chelating agent which is 2,2'-bipyridyl or a derivative thereof containing one or more substituents in the bipyridyl ring structure or by a chelating agent which is 1,10-phenanthroline or a derivative thereof containing one or more substituents in the phenanthroline ring structure. Substituents may themselves be formed in a separate bridging or ring structure, eg they may be in a separate aromatic ring fused to the basic structure, eg such as in a naphthyl or biquinoline structure, formed with one or more of the rings of the bipyridyl or phenanthroline structure.

Thus, if one or more pairs of the ligands L are formed from a 2,2'-bipyridyl structure, the 2,2'-bipyridyl structure may contain hydrogen in the 3,4,5,6,3',4',5' and 6' positions or a

substituent group in or attached to any one or more of these positions. Preferably, where two or more substituent groups are included in the 2,2'-bipyridyl structure these are identical groups.

Likewise, if one or more pairs of the ligands L are formed from a 1,10-phenanthroline structure, the 1,10-phenanthroline structure may contain hydrogen in the 2,3,4,5,6,7,8 and 9 positions or a substituent group in or attached to any one or more of these positions.

Preferably if two or more substituent groups are included in the 1,10-phenanthroline structure these are identical groups.

Preferably, where one or more substituents are contained in a 2,2'-bipyridyl structure or a 1,10-phenanthroline structure they are aryl groups, preferably monocyclic aryl.

Particular mention should be made of complexes of Formula $ML_6Z$ which contain at least two pairs of the ligands L, each pair provided by a 4,4'-disubstituted 2,2'-bipyridyl of Formula II as follows:

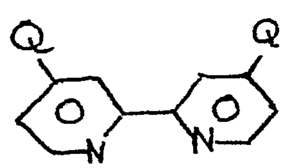

Formula II

where each Q is a monocyclic aryl group preferably phenyl or substituted phenyl. These complexes are dyes showing a particularly high quantum efficiency.

Particular mention should also be made of complexes of Formula $ML_6Z$ which contain at least two pairs of the ligands L, each pair of the ligands being provided by a 4,7-disubstituted 1,10-phenanthroline of Formula III as follows:

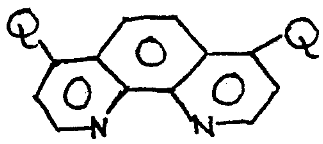

Formula III

where Q is a monocyclic aryl group preferably phenyl or substituted phenyl. These complexes are dyes showing a particularly high quantum efficiency.

One or more of the ligands L included in $L_6$ may carry a negative charge affecting the overall charge of $ML_6$. For example, one or more of the ligands L may be halogens or ionic organic groups such as $COO^-$. Where the total negative charge provided by such ligands is equal to the total positive charge provided by the metal M no additional neutralising ion Z is required. However, where $ML_6$ is a cation, whether or not ionic groups are included in $L_6$, one or more ions Z are required to form a neutral compound.

For example, where M is Ru(II) or Os(II) and the six ligands $L_6$ are provided by three heterocyclic organic molecules each ligand-bonded at two of its non-metal atoms to the metal M, eg by a 2,2'-bipyridyl or a 1,10-phenanthroline structure, the overall charge of $ML_6$ is +2.

In other words, the ligands L do not contribute to the overall charge of $L_6$. One or more additional anions Z providing a charge of -2, eg two anions having a single negative charge, are required to provide a neutral compound.

Where M is Ir(III) for example, and four of the ligands L are provided by two heterocyclic organic molecules each ligand-bonded to the metal M at two non-metal atoms in the heterocyclic molecule, eg in a 2,2'-bipyridyl or a 1,10-phenanthroline structure, and

the other two ligands are provided by halogens, the overall charge on $ML_6$ is +1. The additional anion Z having a single negative charge is required to provide a neutral compound in this case.

Preferably, where an anion Z is present it is a halogen, eg Cl. Preferably where two or more anions Z are present they are identical and are both halogens, although they may also be $ClO_4^-$ or other anions.

Preferably, free oxygen is removed from the dye and host material used in the optical concentrator device according to the present invention before incorporation therein. For example, where the dye is in a liquid solution the solution is deaerated and where the dye is to be contained in plastic the plastic is dearated before setting.

The dyes formed from complexes of Formula $ML_6Z$ may be mixed with other fluorescent dyes, eg with other dyes of Formula $ML_6Z$ and/or with known dyes, eg rhodamines, to give a better overall dye excitation spectrum, as explained in detail below, before incorporation in the device according to the present invention.

The optical concentrator device according to the present invention may, for example, be a fluorescent light activated display, a solar collector device or a dye laser constructed in a known manner as described above, or any one of the other devices of this kind mentioned in US Patent No 4,260,219.

The host material is chosen according to the particular application, but may, for example, be a solid, eg a plastics material such as polyvinyl acetate, polyvinyl chloride or polymethyl methacrylate. Alternatively, the host material may be a liquid. For example it may be an organic solvent eg ethanediol. The liquid may be held in or passed through a transparent container eg a cell containing glass or transparent windows. If the liquid is held in the container, the container may include means permitting the liquid to be replaced from time to time.

A solid host material particularly a plastics material will normally be used in a solar collector device and in a fluorescent light activated display whilst a liquid host material will normally be used in a dye laser.

For instance, a solar collector device may comprise a film of plastics material having uniformly distributed in it a dye comprising a complex of the Formula $ML_6Z$ and at least one solar cell located adjacent to a surface of the film to receive radiation absorbed and re-emitted by the dye and internally reflected and hence concentrated by the film. In this case the radiation receiving and emitting areas are provided by surfaces of the film, the former being a free area of the film and the latter an area adjacent to a solar cell.

Where the device is a fluorescent light activated display it may comprise an electro-optical light modulating device and a layer of the host material containing the dye comprising a complex of Formula $ML_6Z$ positioned behind the light modulating device, the radiation receiving and emitting areas being provided by surfaces of the host material. In this case the radiation emitting area comprises one or more regions of decreased internal reflectivity formed on a surface of the host material to correspond with information displayed by the light modulating device.

Where the device is a dye laser it may comprise plane facing mirror surfaces at least one of which is partially internally reflecting and provides said radiation emitting area, a container containing a liquid laser active medium between said mirror surfaces, the container being transparent and providing said radiation receiving area, and means for irradiating the laser active medium to cause stimulated emission of radiation by said liquid laser active medium between said mirror surfaces, wherein the liquid laser active medium comprises a liquid host containing a dye comprising a complex of Formula $ML_6Z$ as specified above.

According to the invention in another aspect a composition suitable for use in any one of the devices specified above which utilise a solid host material comprises a plastics (high polymeric) material incorporating, preferably having uniformly distributed in it, a fluorescent dye comprising a complex of the formula $ML_6Z$ specified above.

Preferably free oxygen has been removed from the materials forming the said composition.

The plastics material may be polyvinyl chloride, polyvinyl acetate or polymethylmethacrylate.

Where M is Ru(II) or Os(II) the concentration of the complex in the plastics material is preferably between $5x10^{-3}$ and $10^{-5}$, desirably between $9x10^{-4}$ and $2.2x10^{-5}$, moles per mole of the solid plastics material.

Where M is Ir(III) the concentration of the complex in the plastics material by weight is between 1 part of the complex in 500 parts of the plastics material and 1 part of the complex in 10,000 parts of the plastics material, desirably about 1 part in 2,000.

According to the present invention in another aspect there is provided a film of the composition as specified above. Preferably, the film has a thickness in the range 0.5 to 10 mm, desirably in the range 1 to 5 mm.

Where the film is for use particularly in a solar collector device it preferably has a thickness as specified above and is specially fabricated with a large area, eg greater than $10^{-2}$ square metres, desirably greater than 1 square metre.

According to the present invention in another aspect there is provided a novel complex of formula $ML_6Z$ suitable for use in the optical concentrator device specified above which complex may be represented by the formula $M^1Y^1Y^2Y^3Z^2$, where $M^1$ is selected from Ru(II) and Os(II), $Z^2$ represents one or two anions having an overall negative charge of 2, and each of $Y^1$, $Y^2$ and $Y^3$ is independently selected from a structure containing a 2,2'-bipyridyl nucleus or a structure containing a 1,10-phenanthroline nucleus, at least one of $Y^1$, $Y^2$ and $Y^3$ carrying at least one substituent in the 2,2'-bipyridyl or 1,10-phenanthroline nucleus provided that the substituent is other than deuterium and that where $Y^1$, $Y^2$ and $Y^3$ are identical and are 2,2'-bipyridyl structures the substituent if in the 4,4'-positions is other than methyl and phenyl and if in the 5,5'-positions is other than COOH, methyl, and COOR, where R is simple alkyl, and that where $Y^1$, $Y^2$ and $Y^3$ are identical and are 1,10 phenantroline structures the substituent if in the 5 position is other than nitro, chloro, phenyl and methyl, if in the 4,7 positions is other than phenyl and methyl and if in the 5,6 positions is other than methyl and oxygen.

Preferably, two or three of $Y^1$, $Y^2$ and $Y^3$ are identical.

Preferably, the substituted structure contains substituents in the 4,4'-positions where the structure is a 2,2'-bipyridyl and in the 4,7-positions where the structure is a 1,10-phenathroline.

The substituents may themselves form a separate bridging group or ring structure, eg fused to one of the rings of the bipyridyl or phenathroline structure.

Examples of suitable substituents (subject to the proviso specified above) are: halogens eg Cl; nitro; $C_{1-12}$ alkyl; $C_{1-12}$ alkoxy; phenyl; substituted phenyl eg alkyl or alkoxy or halo substituted phenyl, eg p-substituted; $CH=CH-C_6H_5$, OPh, $OCH_2Ph$ $CH_2Ph$ or $CH_2Ph$ where Ph=phenyl; $NH_2$; $NR_1R_2$ where $R_1$ and $R_2$ are simple ($C_1$ to $C_5$)alkyl ; $NHCOR_3$, $R_3$ = alkyl; $CH=CHC_6H_4J$ where J is a para-substituent such as phenyl, nitro, amino, halo, alkyl or alkoxy; $CONHNH_2$; $CONHNHR_3$; $CON_3$; $COOR_3$, tolyl; biphenyl, naphthyl, pyridyl, thienyl.

According to the present invention there is also provided a novel complex of the formula $ML_6Z$ suitable for use in the optical concentrator device specified above which complex may be represented by the formula $M^2Y^4Y^5W^1W^2Z^3$, where $M^2$ is Ir(III), $Z^3$ represents an anion group, $W^1$ and $W^2$ are halogens and each of $Y^4$ and $Y^5$ is independently selected from an optionally substituted structure containing a 2,2'-bipyridyl or a 1,10-phenanthroline nucleus.

Preferably $Y^4$ and $Y^5$ are identical and $W^1$ and $W^2$ are identical eg both are Cl. Preferably, $Z^3$ is a halogen eg I. Preferably $Y^4$ and $Y^5$ if 2,2'-bipyridyl and if substituted are substituted in the 4,4'-positions and if 1,10-phenanthroline are substituted in the 4,7-positions. Substituents, if present may themselves form a separate bridging or ring structure, eg a ring fused to one of the rings of the bipyridyl or phenanthroline structure.

Generally speaking, dyes of Formula $ML_6Z$ show improved absorption of ambient light and reduced self-absorption compared with known dyes used in optical concentrator devices. It is believed that these advantages are obtained for the following reasons.

a. The absorption spectrum of the complexes of Formula $ML_6Z$ includes both the ligand absorption bands and an allowed metal $\rightarrow$ ligand charge transfer transition which lies to lower energy. This combination of absorption bands gives a wider spectral absorption range to the complex ion.

b. The luminescence of the complexes of Formula $ML_6Z$ is assigned as a spin-forbidden triplet $\rightarrow$ singlet component of the charge transfer transition. The corresponding absorption transition is weak, since it is also spin-forbidden. There is therefore a spectral region of low absorption between the luminescence band and the onset of strong charge-transfer absorption. This reduces the self-absorption of luminescence in use in the optical concentrator device according to the present invention which depends on the reflection of luminescent radiation over relatively long path lengths.

For these reasons special additives to the dye as proposed in US Patent No 4,260,219 are not required.

Complexes having Formula $ML_6Z$ may be prepared by known synthetic procedures. Some of these complexes are, in fact, known per se but these known complexes have never been suggested for use in optical concentrator devices as defined above.

Examples of preparation procedures which have been carried out to obtain examples of complexes of Formula $ML_6Z$ and examples of the properties of some of the complexes which have been obtained and examples of devices making use of the

complexes obtained will now be described with reference to the accompanying drawings, in which:

Figure 1 is a graph of intensity v wavelength, ie an absorption and emission spectrum, for a particular complex of Formula $ML_6Z$ above;

Figure 2 is a graph of intensity v wavelength for another particular complex of Formula $ML_6Z$;

Figure 3 is a graph of intensity v wavelength for an organic dye whose use in optical concentrator devices is known;

Figure 4 is a graph of relative detected quantum efficiency (QE) v wavelength, ie an excitation spectrum, for two dyes, one of Formula $ML_6Z$, and a mixture of them;

Figure 5 is an exploded perspective view of a fluorescent light activated display embodying the invention;

Figure 6 is a cross-sectional view of a planar solar collector device embodying the present invention;

Figure 7 is a cross-sectional view of a dye laser embodying the present invention.

(I) AVAILABILITY OF THE LIGANDS TO PREPARE THE COMPLEXES

1. A number of compounds providing the ligands were commercially available. These are listed in Tables 1 to 4 as follows:

TABLE 1: Commercially available 2,2'-bipyridyl compounds

| Compound No. | Substituents in 2,2'-bipyridyl structure |
|---|---|
| 1 | None |
| 4m | 4,4'-diphenyl |
| 4n | 4,4'-dimethyl |

TABLE 2: Commercially available 2,2'-biquinoline compounds

| Compound No. | Substituents |
|---|---|
| 6 | None |

TABLE 3: Commercially available tri-2-pyridyl-s-triazine

| Compound No. | Substituents |
|---|---|
| 7 | None |

TABLE 4: Commercially available 1,10-phenanthroline compounds

| Compound No. | Substituents in 1,10-phenanthroline structure |
|---|---|
| 11 | None |
| 12n | 4-methyl |
| 13a | 5-nitro |
| 13b | 5-chloro |
| 13m | 5-phenyl |
| 13n | 5-methyl |
| 14m | 4,7-diphenyl |
| 14n | 4,7-dimethyl |
| 17 | 5,6-dimethyl |
| 18 | 5,6-dione |
| 19 | 3,4,7,8-tetramethyl |

2. The compound 3,3', 4,4', 5,5', 6,6' perdeutero-2,2'-bipyridyl (compound No 2) was obtained from bipyridyl by base catalysed H/D exchange on the bis oxide. This is a known compound.

3. Monosubstituted 2,2'-bipyridyls as given in Table 5 were prepared by minor modifications of literature methods; 4-nitro 2,2'-bipyridyl 1-oxide was used as an intermediate. On deoxygenation it gave compound 3a (see Table 5). On reaction with $PCl_3$ and acetyl chloride it gave compound 3b. The other compounds 3c to 3j

were prepared by reaction of the intermediate mentioned above or compound 3b with the appropriate nucleophile.

TABLE 5: Monosubstituted 2,2'-bipyridyls

| Compound No. | Substituents in 2,2'-bipyridyl structure |
|---|---|
| 3a | 4-nitro |
| 3b | 4-chloro |
| 3c | 4-bromo |
| 3e | 4-$OCH_2$-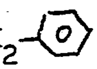 |
| 3f | 4-methoxy |
| 3i | 4-amino |
| 3j | 4-$N(CH_3)_2$ |

4. Certain disubstituted 2,2'-bipyridyls were prepared using literature methods analogous to those used for the monosubstituted 2,2'-bipyridyls mentioned above. These disubstituted compounds are listed in Table 6.

TABLE 6: Certain disubstituted 2,2'-bipyridyls

| Compound No. | Substituents in 2,2'-bipyridyl structure |
|---|---|
| 4a | 4,4'-dinitro |
| 4b | 4,4'-dichloro |
| 4c | 4,4'-dibromo |
| 4d | 4,4'-di(-O-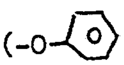) |
| 4e | 4,4'-di(-O-$CH_2$-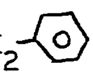) |
| 4g | 4,4'-diethoxy |
| 4i | 4,4'-diamino |
| 4k | 4,4'-di($N(Et)_2$) |

5. Compound 4i (in Table 6 above) was acylated in a standard way to give compound 4l, which is 4,4'di(methylacylamino) 2,2'-bipyridyl. Compound 4n in Table 1 was oxidised and esterified to give 4,4'-dicarboethoxy 2,2'-bipyridyl, 4v. 4,4'-Dibenzyl-2,2'-bipyridyl,4w, was prepared by coupling 4-benzylpyridine using a literature method.

6. The bis-styryl derivative of 2,2'-bipyridyl was prepared by condensing 4,4'-dimethyl-2,2'-bipyridyl with benzaldehyde according to literature methods. The resultant compound is listed in Table 7.

TABLE 7: Certain bis-styryl derivatives of 2,2'-bipyridyl

| Compound No. | Substituents in 2,2'-bipyridyl structure |
|---|---|
| 4o | 4,4'-di(CH=CH-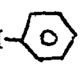) |

7. Certain other disubstituted bipyridyls were prepared by literature methods as listed in Table 8 (using compound 5n as a precursor in the case of the compounds other than 5n listed in Table 8).

TABLE 8: Certain disubstituted derivatives of 2,2'-bipyridyl

| Compound No. | Substituents in 2,2'-bipyridyl structure |
|---|---|
| 5c | 5,5'-dibromo |
| 5i | 5,5'-diamino |
| 5j | 5,5'-di($N(CH_3)_2$) |
| 5l | 5,5'-di($NHCOCH_3$) |
| 5n | 5,5'-dimethyl |
| 5u | 5,5'-di(CO.OH) |
| 5v | 5,5'-di($CO.OC_2H_5$) |
| 5w | 5,5'-di($CO.NHNH_2$) |
| 5x | 5,5'-di($CON_3$) |

8.. A number of substituted phenanthrolines were prepared by essentially literature methods or adaptations of such methods. These are given in Table 9 as follows.

TABLE 9: Substituted 1,10-phenanthrolines

| Compound No. | Substituents in 1,10-phenanthroline structure |
|---|---|
| 12b | 4-chloro |
| 12d | 4-phenoxy |
| 12h | 4-hydroxy |
| 12m | 4-phenyl |
| 12q | 4-p-methylphenyl |
| 12r | 4-p-methoxyphenyl |
| 12s | 4-p-bromophenyl |
| 12t | 4-p-biphenyl |
| 14b | 4,7-dichloro |
| 14h | 4,7-dihydroxy |
| 14q | 4,7-di-p-methylphenyl |
| 14r | 4,7-di-p-methoxyphenyl |
| 14s | 4,7-di-p-bromophenyl |
| 14t | 4,7-di-p-biphenyl |
| 14y | 4,7-di-β-naphthyl |
| 14z | 4,7-di-2-pyridyl |
| 14aa | 4,7-di-α-thienyl |
| 14ab | 4,7-di-3,4-dimethylphenyl |
| 14ac | 4,7-di-2,4-dimethylphenyl |
| 14ad | 4,7-di-2,5-dimethylphenyl |
| 15rs | 4-p-bromophenyl-7-p-methoxyphenyl |
| 15st | 4-p-biphenyl-7-p-bromophenyl |
| 15rt | 4-p-biphenyl-7-p-methoxyphenyl |
| 15mt | 4-p-biphenyl-7-phenyl |

9. 3,5,6,8-tetrachloro-1,10-phenanthroline, compound No. 16 and 3,5,5',6,6'-8-hexachloro-1,10-phenanthroline, compound No. 17, were prepared by chlorination of 1,10-phenanthroline using $SOCl_2$-$SO_2Cl_2$ in a literature method.

(II) PREPARATION OF THE COMPLEXES FROM THE LIGANDS

1. Ru (II) complexes were prepared by one of four methods as follows, which are known per se:

(i) refluxing 3 equivalents of the heteromolecule (providing 2 ligands) with 1 equivalent of $RuCl_3$ in 95% ethanol for about 3 days; or

(ii) refluxing 3 equivalents of the heteromolecule with 1 equivalent of $K_2RuCl_5.H_2O$ in aqueous dimethylformamide in the presence of a reducing agent; or

(iii) heating 3 equivalents of the heteromolecule with 1 equivalent of $K_2RuCl_5.H_2O$ in glycerol at 220°C for 1 hour;

(iv) Complexes of the form $Ru(II)HHH'Z^AZ^A$

where H and H' are heterocyclic molecules providing bidentate ligands, eg 2,2'-bipyridyls, H≠H', and $Z^A$ is a halogen, were prepared by reacting a bis complex of the form $Ru(II)HHZ^AZ^A$ with a stoichiometric amount of H' in ethanolic solution heated under reflux.

In all cases the complexes were precipitated from solution by addition of appropriate acids or salts.

2. Os (II) complexes were prepared by methods which are known using $NH_4^+$ or $K^+$ salts of $OsBr_6^{--}$ or $OsCl_6^{--}$ under conditions similar to those used for the production of the Ru (II) complexes.

3. Cis-dichlorobis complexes of Ir(III), $[Ir(III)cisCl_2L^1_4.Z]$ where $L^1_4$ represents 4 ligands provided by 2 heterocyclic molecules, and Z is an defined above, were prepared by heating two equivalents of a ligand-providing heteromolecule with one equivalent of $K_3IrCl_6$ in glycerol at 190-200° for 1 to 3 hours, with stirring. The complexes were precipitated from solution by addition of appropriate acids or salts, eg iodides.

The following preparative example illustrates the preparation (in Steps (i) and (ii)) of one of the above ligand-providing heteromolecules (compound No. 14ab) and its subsequent conversion (in Step (iii)) into a complex (Complex No. C79).

Preparative example:

Preparation of $Ru(4,7\text{-di}(3'4'\text{-dimethylphenyl})phen)_3Cl_2$

Step (i) Preparation of 3-chloro-3'4'-dimethylpropiophenone (I) (known compound)

This compound of Formula:

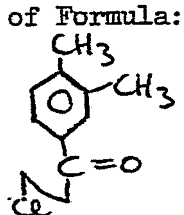

Formula A

was prepared according to the method descibed by

P. Olavi, I.Virtanen and Heikki Ruotsalainen in Annales Academiae Scientiarum Fennicae Series A II Chemica 143 (1968) from o-xylene. The m.p. of the compound was found to be 70°C.

Step (ii) Preparation of 4,7-di(3'4'-dimethylphenyl)Phen)(II)

This compound has the formula:

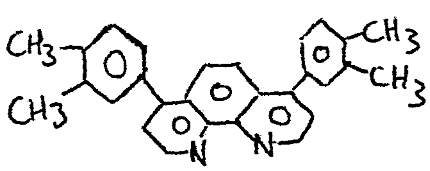

Formula B

Concentrated HCl (200 ml) was heated up to 80-100° and to this was added o-phenylenediamine (7.29 g). When all the diamine has dissolved the product of Step (ii) (29.16 g) was quickly added, and the mixture was then stored at 90-100° for 4 hours. It was then cooled to room temperature and left to stand overnight. The resulting precipitate was filtered off and washed with dichloromethane until the washings were colourless. The pale yellow needle crystals of B-HCl where B is the required heteromolecule were treated with aqueous ammonia and dichloromethane. The organic layer was separated, washed until neutral and evaporated to give the free ligand-providing heteromolecule B. Trituration with petroleum ether and drying at 110°/20 mm gave the product as a white solid, 5.2 g 20% m.p. 192°.

The analytical results for the product were:

C, 86.57; H, 6.22; N, 7.18; $C_{28}H_{24}N_2$). The corresponding figures required by theory are:

C, 86.55; H, 6.24; N, 7.21%).

Step (iii) <u>Preparation of Tris-4,7-di(3'4'-dimethylphenyl)-1,10-phenanthroline ruthenous chloride</u>

Ruthenium trichloride monohydrate (0.145 g) and the product of Step (ii) (ie the compound of Bormula B) (0.75 g) were heated in refluxing 95% ethanol (200 ml) for 72 hours. Ethanol (150 ml) was then removed under reduced pressure. Hydrochloric acid (6N, 70 ml) was added to the residual solution. The orange precipitate was filtered off and washed well with cold water and dried (100°/20 mm) (0.9 g, 98%).

The analytical results for the product were:

C, 70.70; H, 5.73; N, 5.31; Cl,4.54. $(C_{84}H_{72}N_6)Cl_2.5.5\ H_2O$

The corresponding figures required by theory are:

C, 70.22; H, 5.83; N, 5.85; Cl, 4.93%).

(III) INCORPORATION INTO FILMS

The Ru(II) and Os(II) complexes prepared as described above were incorporated into low molecular weight polymer films as follows.

To viscous solutions of plastics (polyvinyl acetate in ethanol, polymethylmethacrylate in chloroform, polyvinyl chloride in chlorobenzene) was added with stirring the complex dissolved in the corresponding solvent (except for addition to polyvinylchloride where a solvent such as acetone or acetonitrile was used). The resultant homogeneous solutions were contained in moulds and the solvent evaporated in air over several days.

The concentration of the complex in the film was between $9 \times 10^{-4}$ and $2.2 \times 10^{-5}$ moles per mole of the solid plastics material, generally $1 \times 10^{-5}$ moles per mole of the solid plastics material.

Ir(III) complexes were incorporated into polyvinyl chloride (PVC) films by heating PVC pellets together with the appropriate complex. The quantities used were 1 mg of complex per 2 g of pellets.

(IV) ABSORPTION AND EMISSION SPECTRA

The absorption spectrum and the emission spectrum were measured for two complexes of Formula $ML_6Z$ Ru(2,2'-bipyridyl)$_3Cl_2$ and Os(2,2'bipyridyl)$_3I_2$ and the results obtained are illustrated in Figures 1 and 2 respectively. A is the absorption spectrum and E the emission spectrum in each ease. As can be seen there is a very small overlap between the spectra A and E in each case. Figures 1 and 2 should be contrasted with the corresponding spectra A and E for the known dye rhodamine B, which as shown in Figure 3, show a much greater degree of overlap.

(V) QUANTUM EFFICIENCY (QE) MEASUREMENTS

1. Relative QE measurements of liquid solutions of the complexes were measured by comparison of the emission intensity of the sample with that of a standard solution of rhodamine B. The sample and standard were excited at the same wavelength and absorbance, selected between 360 and 540 nm and the emission recorded at 90° to the exciting beam by a monochromator-photomultiplier combination detector. The detection system was calibrated for spectral response using a Hilger-Watts thermopile to allow emission spectra to be corrected and plotted as relative numbers of photons emitted versus wavelength. The area under such a curve is proportional to the number of photons emitted. Rhodamine B is taken to have the QE (in absolute terms) of 0.73, as determined by previous work.

2. Relative QE measurements of the complexes in thin plastic films, about 1 mm thick, formed as in (III) above were determined by observing the emitted light at an angle of 180° to the exciting beam. This avoids erroneously high values being given by total internal reflection within the thin film.

3. Liquid solutions of the complexes were depleted of free oxygen by degassing in an optical cell fitted with a side-arm in the following way. The solution was frozen to 77K in the wide-arm and the gas above the solid solution was pumped away to a pressure of $10^{-5}$ mm Hg. The solution was allowed to warm to room temperature under vacuum so that it outgassed into the vacuum space. This freeze-pump-thaw cycle was repeated twice. Relative QE measurements for the degassed solutions obtained in this way were then measured as described under (1) above.

The complexes investigated are listed below in Table 10 and results obtained are listed in Tables 11, 12, 13 and 14 which follow where the following symbols are used:

| | | |
|---|---|---|
| bipyr | = | 2,2'-bipyridyl |
| phen | = | 1,10-phenanthroline |
| bipyr-d | = | deuterated 2,2'-bipyridyl |
| Ph | = | phenyl |
| Me | = | methyl |
| Et | = | ethyl |
| D | = | deuterium |
| EPA | = | diethyl ether: 3-methylpentane: ethyl alcohol, in a ratio of 5:3:2 parts by volume |
| QE | = | quantum efficiency |
| DMSO | = | dimethylsulphoxide |
| DMF | = | dimethylformamide |
| PVA | = | polyvinyl acetate |
| PVC | = | polyvinyl chloride |
| PMMA | = | polymethyl methacrylate |
| St | = | styryl |

TABLE 10: List of complexes

| Ligand No. | Complex No. | Complex |
|---|---|---|
| 1 | C1 | $Ru(bipyr)_3Cl_2$ |
| 4b | C2 | $Ru(4,4'\text{-diClbipyr})_3Cl_2$ |
| 4c | C3 | $Ru(4,4'\text{-diBrbipyr})_3I_2$ |
| 4v | C4 | $Ru(4,4'\text{-di}CO_2\text{Etbipyr})_3Cl_2$ |
| 5v | C5 | $Ru(5,5'\text{-di}CO_2\text{Etbipyr})_3I_2$ |
| 5n | C6 | $Ru(5,5'\text{-diMebipyr})_3Cl_2$ |
| 4n | C7 | $Ru(4,4'\text{-diMebipyr})_3Cl_2$ |
| 4g | C8 | $Ru(4,4'\text{-diOEtbipyr})_3I_2$ |
| 4d | C9 | $Ru(4,4'\text{-diOPhbipyr})_3Cl_2$ |
| 4w | C10 | $Ru(4,4'\text{-di}CH_2\text{Phbipyr})_3I_2$ |
| 4e | C11 | $Ru(4,4'\text{-diO}CH_2\text{Phbipyr})_3Cl_2$ |
| 4o | C12 | $Ru(4,4'\text{-diStbipyr})_3Cl_2$ |
| 4m | C13 | $Ru(4,4'\text{-diPhbipyr})_3Cl_2$ |
| 1+2(4m) | C14 | $Ru(bipyr)_1(4,4'\text{-diPhbipyr})_2I_2$ |
| 2(1)+4m | C15 | $Ru(bipyr)_2(4,4'\text{-diPhbipyr})_1I_2$ |
| 2(4m)+14y | C16 | $Ru(4,4'\text{-diPhbipyr})_2(4,7\text{-di-}\beta\text{-naphthylphen})_1I_2$ |
| 4k | C17 | $Ru(4,4'\text{-diNEt}_2\text{bipyr})I_2$ |
| 4i | C18 | $Ru(4,4'\text{-diNH}_2\text{bipyr})I_2$ |
| 4l | C19 | $Ru(4,4'\text{-diNHCOCH}_3\text{bipyr})_3I_2$ |
| 5l | C20 | $Ru(5,5\text{-diNHCOCH}_3\text{bipyr})_3I_2$ |

TABLE 10: List of complexes (Continued)

| Ligand No. | Complex No. | Complex |
|---|---|---|
| 4a | C21 | $Ru(4,4'-diNO_2bipyr)_3BF_4$ |
| 3b | C22 | $Ru(4-Clbipyr)_3I_2$ |
| 3c | C23 | $Ru(4-Brbipyr)_3I_2$ |
| 3f | C24 | $Ru(4-OMebipyr)_3I_2$ |
| 3a | C25 | $Ru(4-NO_2bipyr)_3I_2$ |
| 3e | C26 | $Ru(4-OCH_2Phbipyr)_3I_2$ |
| 3i | C27 | $Ru(4-NH_2bipyr)_3I_2$ |
| 3j | C28 | $Ru(4-NMe_2bipyr)_3I_2$ |
| 11 | C29 | $Ru(phen)_3I_2$ |
| 12n | C30 | $Ru(4-Mephen)_3I_2$ |
| 13n | C31 | $Ru(5-Mephen)_3Cl_2$ |
| 13b | C32 | $Ru(5-Clphen)_3Cl_2$ |
| 12d | C33 | $Ru(4-OPhphen)_3Cl_2$ |
| 12m | C34 | $Ru(4-Phphen)_3Cl_2$ |
| 12q | C35 | $Ru(4-tolylphen)_3Cl_2$ |
| 12t | C36 | $Ru(4-biphenylphen)_3Cl_2$ |
| 12s | C37 | $Ru(4-bromophenylphen)_3Cl_2$ |
| 12b | C38 | $Ru(4-Clphen)_3I_2$ |
| 12r | C39 | $Ru(4-OMePhphen)_3Cl_2$ |
| 13n | C40 | $Ru(5-Phphen)_3I_2$ |

TABLE 10: List of complexes (Continued)

| Ligand No. | Complex No. | Complex |
|---|---|---|
| 13a | C41 | $Ru(5\text{-}NO_2phen)_3(ClO_4)_2$ |
| 14n | C42 | $Ru(4,7\text{-}diMephen)_3Cl_2$ |
| 14m | C43 | $Ru(4,7\text{-}diPhphen)_3I_2$ |
| 14s | C44 | $Ru(4,7\text{-}diBrPhphen)_3Cl_2$ |
| 14q | C45 | $Ru(4,7\text{-}ditolylphen)_3Cl_2$ |
| 14b | C46 | $Ru(4,7\text{-}diClphen)_3I_2$ |
| 17 | C47 | $Ru(5,6\text{-}diMephen)_3I_2$ |
| 19 | C48 | $Ru(3,4,7,8\text{-}tetraMephen)_3Cl_2$ |
| 15mt | C49 | $Ru(4\text{-}PhPh,7\text{-}Phphen)_3Cl_2$ |
| 15rs | C50 | $Ru(4\text{-}BrPh,7\text{-}MeOPhphen)_3Cl_2$ |
| 15rt | C51 | $Ru(4\text{-}PhPh,7\text{-}MeOPhphen)_3Cl_2$ |
| 15st | C52 | $Ru(4\text{-}PhPh,7\text{-}BrPhphen)_3Cl_2$ |
| 1 | C53 | $Os(bipyr)_3I_2$ |
| 5n | C54 | $Os(5,5\text{-}diMebipyr)_3I_2$ |
| 4m | C55 | $Os(4,4\text{-}diPhbipyr)_3I_2$ |
| 11 | C57 | $Os(phen)_3I_2$ |
| 14m | C58 | $Os(4,7\text{-}diPhphen)_3I_2$ |
| | C59 | $Ru(bipyr\text{-}d_8)_3Cl_2$ |
| | C60 | $Ru(4,7\text{-}diPhPhphen)_3Cl_2$ |
| | C56 | $Os(4,4'\text{-}diCO_2Etbipyr)_3I_2$ |
| 14ab | C79 | $Ru(4,7\text{-}di[3',4'\text{-}dimethylphenyl]phen)_3Cl_2$. |

TABLE 11: Absorption and luminescence properties of tris-chelates of Ru(II) and Os(II) as listed in Table 10

All measurements at room temperature with the complex contained in an EtOH/MeOH solution.

| Complex No. | Relative Quantum Efficiency (aerated) | Relative Quantum Efficiency (deaerated) | Absorption maximum (nm) | Emission maximum (nm) |
|---|---|---|---|---|
| C1 | 0.033 | 0.101 | 450 | 630 |
| C2 | 0.025 | 0.047 | 465 | 670 |
| C3 | 0.035 | 0.075 | 465 | 660 |
| C4 | 0.095 | 0.250 | 463.5 | 655 |
| C5 | 0.004 | 0.005 | 495 | 720 |
| C6 | 0.019 | 0.046 | 440 | 620 |
| C7 | 0.034 | 0.109 | 455 | 640 |
| C8 | 0.011 | 0.025 | 477 | 670 |
| C9 | 0.022 | 0.048 | 478.8 | 670 |
| C10 | 0.037 | 0.122 | 460 | 640 |
| C11 | 0.019 | 0.040 | 476 | 670 |
| C12 | 0.011 | 0.037 | 487 | 680 |
| C13 | 0.073 | 0.382 | 473 | 640 |
| C14 | 0.030 | 0.123 | 465 | 635 |
| C15 | 0.051 | 0.246 | 457.5 | 630 |
| C16 | 0.016 | 0.145 | 469 | 635 |
| C17 | 0.005 | 0.012 | 517.5 | 700 |
| C18 | 0.001 | 0.003 | 504 | 710 |
| C19 | 0.017 | 0.034 | 478.5 | 670 |
| C20 | 0.026 | 0.158 | 445 | 630 |

TABLE 11: Absorption and luminescence properties of tris-chelates of Ru(II) and Os(II) as listed in Table 10 (Continued)

| Complex No. | Relative Quantum Efficiency (aerated) | Relative Quantum Efficiency (deaerated) | Absorption maximum (nm) | Emission maximum (nm) |
|---|---|---|---|---|
| C21 | 0.001 | 0.003 | 472.5 | 700 |
| C22 | 0.017 | 0.037 | 454 | 640 |
| C23 | 0.022 | 0.065 | 457 | 640 |
| C24 | 0.017 | 0.049 | 461 | 660 |
| C25 | 0.003 | 0.007 | 462 | 660 |
| C26 | 0.021 | 0.066 | 460 | 650 |
| C27 | 0.007 | 0.025 | 472.5 | 680 |
| C28 | 0.008 | 0.029 | 475 | 680 |
| C29 | 0.015 | 0.029 | 445 | 610 |
| C30 | 0.019 | 0.062 | 445 | 620 |
| C31 | 0.026 | 0.067 | 447 | 620 |
| C32 | 0.021 | 0.038 | 446 | 620 |
| C33 | 0.002 | 0.009 | 446 | 635 |
| C34 | 0.012 | 0.150 | 450 | 620 |
| C35 | 0.012 | 0.162 | 452.5 | 615 |
| C36 | 0.014 | 0.211 | 454 | 625 |
| C37 | 0.014 | 0.195 | 451.5 | 625 |
| C38 | 0.011 | 0.041 | 450 | 625 |
| C39 | 0.011 | 0.158 | 452 | 620 |
| C40 | 0.011 | 0.040 | 448 | 615 |
| C41 | 0.000 | 0.001 | 446 | 630 |
| C42 | 0.013 | 0.069 | 445 | 620 |
| C43 | 0.026 | 0.600 | 462.5 | 620 |
| C44 | 0.019 | 0.342 | 464 | 625 |
| C45 | 0.013 | 0.196 | 464 | 620 |
| C46 | 0.010 | 0.028 | 456 | 650 |
| C47 | 0.019 | 0.158 | 450 | 610 |
| C48 | 0.004 | 0.020 | 439 | 620 |
| C49 | 0.025 | 0.491 | 465 | 625 |
| C50 | 0.019 | 0.400 | 464 | 630 |

TABLE 11: Absorption and luminescence properties of tris-chelates of Ru(II) and Os(II) as listed in Table 10 (Continued)

| Complex No. | Relative Quantum Efficiency (aerated) | Relative Quantum Efficiency (deaerated) | Absorption maximum (nm) | Emission maximum (nm) |
|---|---|---|---|---|
| C51 | 0.009 | 0.238 | 468 | 630 |
| C52 | 0.015 | 0.281 | 465 | 625 |
| C53 | 0.014 | 0.018 | 476 | 740 |
| C54 | 0.020 | 0.042 | 465 | 720 |
| C55 | 0.025 | 0.029 | 463 | 765 |
| C56 | 0.012 | 0.013 | 495 | 810 |
| C57 | 0.022 | 0.051 | 427 | 720 |
| C58 | 0.034 | 0.065 | 445 | 740 |
| C79 | 0.027 | 0.614 | 465 | 620 |

The QE(deaerated) result given above in Table 11 for Complex No. C79 illustrates the particularly attractive properties of this particular complex. In fact, this complex is a member of a preferred class of complexes which are a sub-class of those of Formula III above wherein each Q in Formula III is independently 3,4-disubstituted phenyl in which the 3- and 4- substitutents in the phenyl group are selected from optionally substituted alkyl and halo eg, Cl.

Where the 3- and 4- substituents are alkyl groups the alkyl groups preferably have less than 12 carbon atoms, desirably less than 5 carbon atoms. Suitable optional substituents for such groups are alkoxy and halo.

Another preferred class of complexes containing similar ligands are a sub-class of Formula II above wherein each Q in Formula II is independently 3,4-disubstituted phenyl in which the 3- and 4-substitutents in the phenyl group are selected from optionally substituted alkyl and halo.

Where the 3-,4-substituents are alkyl groups the alkyl groups preferably have less than 12 carbon atoms desirably less than 5 carbon atoms. Suitable optional substituents are alkoxy and halo.

TABLE 10: List of complexes (Continued)

| Ligand No. | Complex No. | Complex |
| --- | --- | --- |
| | C61 | $IrCl_2(bipyr)_2I$ |
| | C62 | $IrCl_2(4\text{-}Clbipyr)_2I$ |
| | C63 | $IrCl_2(4\text{-}OMebipyr)_2I$ |
| | C64 | $IrCl_2(4\text{-}NMe_2bipyr)_2I$ |
| | C65 | $IrCl_2(4\text{-}OCH_2Phbipyr)_2I$ |
| | C66 | $IrCl_2(4,4'\text{-}diMebipyr)_2I$ |
| | C67 | $IrCl_2(4,4'\text{-}diClbipyr)_2I$ |
| | C68 | $IrCl_2(4,4'\text{-}diBrbipyr)_2I$ |
| | C69 | $IrCl_2(4,4'\text{-}diPhbipyr)_2I$ |
| | C70 | $IrCl_2(4,4'\text{-}diCO_2Etbipyr)_2I$ |
| | C71 | $IrCl_2(4,4'\text{-}diNEt_2bipyr)_2I$ |
| | C72 | $IrCl_2(4,4'\text{-}diOCH_2Phbipyr)_2I$ |
| | C73 | $IrCl_2(phen)_2I$ |
| | C74 | $IrCl_2(4,7\text{-}diClphen)_2I$ |
| | C75 | $IrCl_2(4,7\text{-}diPhphen)_2I$ |
| | C76 | $IrCl_2(4,7\text{-}diPhPhphen)_2I$ |
| | C77 | $IrCl_2(4,7\text{-}di\text{-}p\text{-}BrPhphen)_2I$ |
| | C78 | $IrCl_2(4,7\text{-}di\text{-}p\text{-}MeOPhphen)_2I$ |

TABLE 12: Table of QE measurements of trischelates of Ru(II) and Os(II) in plastics films. All measurements at room temperature.

| Compound No. | Plastics# Material | QE* | Absorption maximum (nm) | Emission Maximum (nm) |
|---|---|---|---|---|
| C1 | PVAC | 0.237 | 450 | 630 |
| C59 | PMMA | 0.230 | 448 | 630 |
| C59 | PVC | 0.356 | 450 | 570, 620 |
| C59 | PVAc | 0.404 | 448 | 630 |
| C4 | PVAc | 0.118 | 463 | 645 |
| C13 | PVC | 0.544 | 475 | 610 |
| C12 | PVC | 0.094 | ∿ 485 | 665 |
| C29 | PVC | 0.210 | 445 | 570, 610 |
| C43 | PVC | 0.70 | 465 | 600 |
| C43 | PMMA | 0.44 | 465 | 620 |
| C60 | PVC | 0.645 | 466 | 605 |
| C58 | PVC | 0.36 | ∿ 445 | 700 |
| C58 | PMMA | 0.156 | ∿ 445 | 720 |
| C58 | PVAc | 0.185 | ∿ 445 | 730 |
| Rhodamine B | PMMA | 0.98 | 558 | 580 |

# PVAc = Polyvinylacetate, PVC = Polyvinylchloride,
PMMA = Polymethylmethacrylate.

* Measured relative to a solution of Rhodamine B
< QE = 0.73 > at 180° between excitation and emission beams.

TABLE 13: Solvent dependence of the QE, absorption and emission maxima of selected compounds.

| Compound No. | Solvent | Vacuum deaerated QE | Not vacuum deaerated QE | Absorption maximum (nm) | Emission maximum (nm) |
|---|---|---|---|---|---|
| C1 | $H_2O$ | 0.078 | 0.041 | 452.0 | 640 |
| | $D_2O$ | 0.111 | 0.072 | 451.0 | 635 |
| | EtOH/MeOH | 0.111 | 0.036 | 450.0 | 630 |
| | glycerol | 0.159 | 0.124 | 452.4 | 625 |
| | $CH_3CN$ | 0.153 | 0.040 | 450.0 | 630 |
| | DMSO | 0.164 | 0.062 | 454 | 645 |
| | DMF | 0.161 | 0.035 | 453 | 640 |
| C13 | $H_2O$ | 0.140 | 0.087 | 472.5 | 650 |
| | EtOH/MeOH | 0.380 | 0.072 | 473 | 640 |
| | glycerol | 0.304 | 0.296 | 476 | 640 |
| | $CH_3CN$ | 0.364 | 0.041 | 473 | 640 |
| | DMSO | 0.308 | 0.103 | 478 | 655 |
| | DMF | 0.292 | 0.054 | 477 | 650 |
| C59 | EtOH/MeOH | 0.120 | 0.039 | 448 | 630 |
| | $D_2O$ | 0.132 | 0.084 | 450 | 630 |
| | $H_2O$ | 0.089 | 0.045 | 451 | 630 |

TABLE 14: Summary table of QE measurements of cis-dichlorobischelates of Ir(III) in PVC plastics films. All measurements at room temperature (20°C)

| Complex No. | QE | Absorption maximum (nm) | Emission maximum (nm) |
|---|---|---|---|
| C61 | 0.177 | 392 | 555 |
| C62 | 0.185 | 430 | 570 |
| C63 | 0.182 | 440 | 545 |
| C64 | 0.246 | 440 | 560 |
| C65 | 0.038 | - | 550 |
| C66 | 0.067 | 390 | 520 |
| C67 | 0.154 | - | 615 |
| C68 | 0.087 | - | 620 |
| C69 | 0.574 | 405 | 505 |
| C70 | 0.042 | - | 560 |
| C71 | 0.032 | 395 | 545 |
| C72 | 0.074 | - | 550 |
| C73 | 0.132 | 400 | 530 |
| C74 | 0.060 | 360 | 550 |
| C75 | 0.465 | 410 | 550 |
| C76 | 0.122 | - | 460, 565 |
| C77 | 0.015 | 435 | 560 |
| C78 | 0.446 | - | 570 |

The QE values were measured relative to a solution of Rhodamine B < QE = 0.73 > at 180° between excitation and emission beams.

Table 11 illustrates that deaerating of the solutions of dye complexes of Formula $ML_6Z$ leads to higher quantum efficiencies. It also illustrates the large gap between the absorption maximum and the emission maximum.

Table 12 illustrates that relatively high QE values can be obtained in plastic sheets for dye compounds of Formula $ML_6Z$ which have, in solution, lower QE values.

Table 13 illustrates the solvent dependence of QE values for selected compounds.

Table 14 illustrates that dye compounds of Formula $ML_6Z$ where M = Ir have relatively high QE values when embedded in plastic sheets.

(VI) MIXTURES OF THE Ru AND Os COMPLEXES WITH ORGANIC DYES

It was pointed out above that the absorption process inverse to the luminescence of the Ru and Os complexes of Formula $ML_6Z$ is relatively weak because of its spin-forbidden singlet $\rightarrow$ triplet character. This is particularly true for the Ru compounds, but less so for the Os complexes where the stronger spin-orbit coupling breaks the spin selection rule.

As noted previously this weak absorption is advantageous in reducing self-absorption of the emitted light. However, as a consequence, relatively high concentrations of each complex may be required to achieve useful absorbance in the spectral region immediately to high energy of the luminescence band. Such high concentrations of the active complex can introduce non-radiative concentration quenching of the QE.

This effect presents a problem particularly in the case of Ru complexes, but it may be overcome by using the complexes in mixtures with other dyes, eg a conventional organic dye. Mixtures of Ru $(4,7\text{-diphenylphen})_3I_2$ (where phen = 1,10-phenanthroline) together with known dyes rhodamine 6G and rhodamine B have been investigated in ethanediol. At useful concentration levels there is little interaction between the components of the mixture, so that the absorption and emission properties of the mixture are essentially the sum of the two separate components at the same concentration. This effect is

illustrated by the luminescence excitation spectra of the Ru (4,7-diphenylphen)$_3$I$_2$/Rhodamine B system as shown in Figure 4. The ruthenium complex has an excitation spectrum (detected relative quantum efficiency v wavelength) labelled 1 in Figure 4 whilst rhodamine B has an excitation spectrum labelled 2 in Figure 4. A mixture of these dyes was made with a concentration adjusted to give the same absorbance at the maximum of the absorption spectrum. (Only a low rhodamine concentration was required to fill the spectral gap so the self-absorption for this component was minimised.) The mixture has an emission spectrum labelled 3 in Figure 4. Thus, the mixture gives an emission spectrum better than for the individual dyes because the minimum quantum efficiency is raised giving a more uniform excitation spectrum throughout the region 400-600 nm. The two dye components absorb strongly in different spectral regions, but have rather similar emission spectra in the orange region. The mixture therefore provides the widest possible spectral absorption, but minimises self-absorption problems.

Dye mixtures incorporating only conventional organic dyes (ie not complexes of Formula $ML_6Z$ ) are likely to be less efficient since each component absorbs and emits in a relatively narrow spectral range. The operation of such mixtures therefore generally requires complex energy transfer processes from the higher-energy dye components to the lowest energy, which then emits.

Examples of devices, which are known per se, in which the dyes of Formula $ML_6Z$ may be used will now be described.

As shown in Figure 5 a conventional liquid crystal display cell 11 constructed in a known way comprises a film 13 of liquid crystal material contained between glass slides 15. The film 13 is sealed in a conventional way between the slides 15 by a plastic spacer (which, for the sake of clarity, is not shown in Figure 5). The slides 15 have transparent electrodes 17 eg of tin oxide, on

their respective inner surfaces which electrodes 17 have previously been photoetched in the shape of one or more characters or parts thereof: the character(s) or parts thereof on one slide 15 matching these on the other slide 15. When a voltage from a source (not shown in Figure 5) external to the cell 11 is applied between the electrodes 17 on the respective slides 15 (by way of transparent conducting strips not shown on the inner surfaces of the slides 15), ie across the film 13 the molecular arrangement within the film 13 between those electrodes 17 is changed by a known liquid crystal electro-optical effect (which depends on the liquid crystal material used and the initial alignment - if any - of the material relative to the inner surfaces of the slides 13). This is the "ON" state which is different from the molecular arrangement in those parts of the film 13 not between the electrodes 17 which are in the "OFF" state. An optical contrast is observed between the ON and OFF states of the cell 11 which allows the or each character represented by the electrodes 17 between which the voltage is applied to be displayed. This is illustrated in Figure 5 by display of the letter A. Polarisers (not shown in Figure 5) aligned in a known way may (depending on the liquid crystal electro-optical effect) be positioned in front of the front slide 13 and behind the rear slide 13 in the cell 11 to enhance the display contrast.

A plate 19 of plastic material, eg polymethylmethacrylate, is positioned behind the rear slide 13 (and behind any polariser located behind that slide). The plate 19 has dissolved in it one of the specific dye compounds of Formula $ML_6Z$ which are mentioned above, or a mixture of dyes which includes at least one compound of Formula $ML_6Z$.

All of the surfaces of the plate 19 are polished plane surfaces except in a region 21 on the front surface of the plate 19 where the plate 19 has a roughened surface. The region 21 is located behind and matches the shape of the

electrodes 17 in the cell 11. The edges of the region 21 may slightly overlap the corresponding edges of the electrodes 17.

When ambient light transmitted through the cell 11 reaches the plate 19 it is absorbed by the dye in the plate 19. The dye re-emits its own fluorescent light which is internally reflected many times within the plate 19. Eventually this light leaves the plate 19 at the region 21 which acts as a light outlet for the plate 19. The light is transmitted through the cell 11. If the plate 19 is observed through the cell 11 the character(s) represented by the energised electrodes 17 appear bright by the fluorescence obtained from the plate 19. This known effect is further described, using conventional fluorescent dyes, in US Patent No 4,142,781.

The region 21 could be replaced in an alternative device construction by a uniform rough area behind the liquid crystal cell which only becomes visible when the cell is switched.

Figure 6 shows a planar solar collector construction. Three plates 31, 32 and 33 have rectangular sides and ends and are mutually positioned so that the plate 32 is on top of the plate 33 and the plate 31 is on top of the plate 31. All three of the plates 31, 32, 33 are of plastic material, eg polymethylmethacrylate having one of the dyes of Formula $ML_6Z$ dissolved in it either alone or together with one or more other dyes. A different dye is dissolved in each of the plates 31, 32, 33 in order to enhance the overall dye absorption spectrum. One end of each of the plates 31, 32, 33 is silvered to give mirror surfaces 34, 35, 36 respectively, whilst adjacent to the other ends of the plates are located solar cells 37, 38 and 39, respectively.

When ambient radiation falls on the construction from above as illustrated by a ray 41 in Figure 6 part of the spectrum of the radiation is absorbed by the plate 31. The unabsorbed parts of the spectrum are transmitted to the plate 32 where a further part is absorbed by the plate 32. Finally, parts of the spectrum

absorbed by neither the plate 31 nor the plate 32 are transmitted to the plate 33 where further absorption occurs.

The dye in each plate 31, 32 or 33 re-emits radiation by fluorescence. This re-emitted radiation is guided along the plate 31, 32 or 33 as appropriate to the end having the solar cell 37, 38 or 39 in which it is absorbed. This is illustrated by rays 42, 43 and 44 guided along the plates 31, 32 and 33 respectively. Re-emitted radiation directed initially away from the solar cells 37, 38 and 39 is reflected by the appropriate mirror surface 34, 35 or 36. This is illustrated by a ray 45 in the plate 31.

In an alternative device one or two plates may be used, instead of the three shown in Figure 6, provided that a widely absorbing dye, eg a dye mixture as mentioned above, is used.

In a further alternative device a plastics sheet, eg about 1 mm thick PVC having an area typically 1 $m^2$ has attached to its lower face a series of solar cells, the solar cells ocupying about 50-75% of the surface area of the lower face.

Dye laser constructions are well-known, for example see US Patent No 4,271,395. Dyes of Formula $ML_6Z$ may be used in such known constructions in place of, or together with, dyes known for use in such devices.

For example in the known construction shown in Figure 7 a thin walled quartz container 51 has an inlet port 53 and an outlet port 55 via which a liquid containing the dye comprising a complex of the formula $ML_6Z$ is continuously pumped. The liquid may be water or a simple organic compound such as ethanol. The molar concentration of the dye in the liquid is about 1 mole per litre of liquid.

Light from a nitrogen laser 57 is focussed onto the liquid in the container 51 by a lens 58 causing stimulated emission by the dye therein. Broad-band re-emission in the form of laser light 60 is provided by multiple reflections between the resonator formed by a fully reflecting mirror 59 and a partially reflecting mirror 61 outside the container.

CLAIMS

1. An optical concentrator device including a radiation receiving area, a radiation emitting area, two spaced reflecting surfaces and between the reflecting surfaces a host material incorporating within it a fluorescent dye, wherein the dye comprises a complex of the formula $ML_6$ Z, where: M represents a metal selected from Ru(II), Os(II) and Ir(III); $L_6$ represents a plurality of ligands satisfying six valencies of M, at least one of which ligands is provided by a heterocyclic organic molecule containing at least one non-metal atom capable of ligand-bonding to the metal M; and Z represents one or more ions associated with $ML_6$, Z being present when $ML_6$ carries an overall ionic charge and absent when $ML_6$ carries no overall ionic charge, Z having an overall ionic charge equal and opposite to the overall ionic charge of $ML_6$.

2. A device as claimed in claim 1 and wherein complex is such that the ligand which is provided by a heterocyclic organic molecule containing at least one non-metal atom capable of ligand-bonding to the metal M is provided by an aromatic organic molecule.

3. A device as claimed in claim 2 and wherein the said non-metal atom is nitrogen.

4. A device as claimed in claim 3 and wherein at least two of the ligands L are provided by a single heterocyclic aromatic molecule containing at least two non-metal atoms ligand-bonded to the metal M, at least one of the non-metal atoms being nitrogen.

5. A device as claimed in claim 4 and wherein at least four of the ligands L are provided by two heterocyclic aromatic molecules each containing a pair of nitrogen atoms, each of the two pairs of nitrogen atoms being ligand-bonded to the metal M.

6. A device as claimed in claim 5 and wherein the said two heterocyclic organic molecules are identical.

7. A device as claimed in claim 6 and wherein the said two heterocyclic organic molecules are 2,2'-bipyridyl structures.

8. A device as claimed in claim 6 and wherein at least one of the ring positions of each of the 2,2'-bipyridyl structures carries a substituent.

9. A device as claimed in claim 7 and wherein the said substituent is an aryl group.

10. A device as claimed in claim 8 and wherein each of the bipyridyl structures contains two substituents each of which is a monocyclic aryl group, and these substituents are in the 4 and 4' positions of the bipyridyl structure.

11. A device as claimed in claim 6 and wherein the said two heterocyclic organic molecules are 1,10-phenanthroline structures.

12. A device as claimed in claim 10 and wherein at least one of the ring positions of each of the 1,10 phenanthroline structures carries a substituent.

13. A device as claimed in claim 11 and wherein the substituent is an aryl group.

14. A device as claimed in claim 12 and wherein the substituent is a monocyclic aryl group and is contained in the 4 and 7 positions of each of the phenanthroline structures.

15. A device as claimed in claim 1 and wherein the six ligands L are provided by three 2,2' - bipyridyl structures each ligand-bonded to the metal M at its nitrogen atoms in the 2,2'-positions, at least two of the three bipyridyl structures being identical, the metal M being selected from Ru(II) and Os(II).

16. A device as claimed in claim 1 and wherein the six ligands are provided by three 1,10-phenanthroline structures each ligand-bonded to the metal M at its nitrogen atoms in the 1,10 positions, at least two of the three phenanthroline structures being identical, the metal M being selected from Ru(II) and Os(II).

17. A device as claimed in claim 1 and wherein of the six ligands L four are provided by two 2,2'-bipyridyl structures each ligand-bonded to the metal M at its nitrogen atoms in the 2,2'-positions, and two are provided by halogen atoms, the metal M being Ir(III) and the complex being a cis-complex.

18. A device as claimed in claim 1 and wherein of the six ligands L four are provided by two 1,10-phenanthroline structures each ligand-bonded to the metal M at its nitrogen atoms in the 1,10 positions and two are provided by halogen atoms, the metal M being Ir(III) and the complex being in a cis-configuration.

19. A device as claimed in claim 1 and wherein the complex has the formula $ML_6Z^1$ where M and $L_6$ are as specified in Claim 1, $ML_6$ is a cation and $Z^1$ represents one or more anions, $Z^1$ being one or more halogens.

20. A device as claimed in claim 1 and wherein the dye comprises a mixture of compounds at least one of which is the said complex.

21. A device as claimed in claim 20 and wherein the dye comprises a mixture of the said complex together with a rhodamine dye compound.

22. A composition suitable for use in a device as claimed in claim 1 the composition comprising a plastics material having uniformly distributed in it a fluorescent dye comprising a complex of the formula $ML_6$ Z as specified in claim 1.

23. A composition as claimed in claim 22 and wherein free oxygen has been removed from the composition.

24. A composition as claimed in claim 23 and wherein the metal M is Ru(II) or Os(II) and the concentration of the complex in the plastics material is between $5 \times 10^{-3}$ and $10^{-5}$ moles of the complex per mole of the solid plastics material.

25. A composition as claimed in clam 24 and wherein concentration of the complex in the plastics material is between $9 \times 10^{-4}$ and $2.2 \times 10^{-5}$ moles per mole of the solid plastics material.

26. A composition as claimed in claim 22 and wherein the metal M is Ir(III) and the concentration of the complex in the plastics material by weight is between 1 part of the complex in 500 parts of the plastics material and 1 part of the complex in 10,000 parts of the plastics material.

27. A film of the composition claimed in claim 22 and wherein the film has a thickness in the range 0.5 to 10 mm.

28. A film as claimed in claim 27 and wherein the film has a thickness in the range 1 to 5 mm.

29. A film as claimed in claim 28 and wherein the film has an area greater than $10^{-2}$ square metres.

30. A film as claimed in claim 28 and wherein the film has an area greater than 1 square metre.

31. A composition as claimed in claim 22 and wherein the plastics material is selected from, polyvinyl-acetate, polymethylmethacrylate and polyvinyl chloride.

31. A device as claimed in claim 1 and wherein the device is a solar collector device comprising a film of plastics material having uniformly distributed in it a dye comprising a complex of the Formula $ML_6Z$ and at least one solar cell located adjacent to a surface of the film to receive radiation absorbed and re-emitted by the dye and internally reflected by the film, the radiation receiving and emitting areas being provided by surfaces of the film.

33. A device as claimed in claim 32 and wherein the thickness of the film is in the range 1 to 5 mm and the area of the film is greater than $10^{-2}$ square metres.

34. A device as claimed in claim 1 and wherein the device is a fluorescent light activated display and comprises an electro-optical light modulating device and a layer of the host material containing the dye positioned behind the light modulating device, the radiation receiving and emitting areas being provided by surfaces of the host material, the radiation emitting area comprising one or more regions of

decreased internal reflectivity formed on a surface of the host material to correspond with information displayed by the light modulating device.

35. A device as claimed in claim 1 and wherein the device is a dye laser and comprises two plane facing mirror surfaces at least one of which is partially internally reflecting and provides said radiation emitting area, a container containing a liquid laser active medium between said mirror surfaces, the container being transparent and providing said radiation receiving area, and means for irradiating the laser active medium to cause stimulated emission of radiation by said liquid laser active medium between said mirror surfaces, wherein the liquid laser active medium comprises a liquid containing a dye comprising a complex of Formula $ML_6Z$ as specified in claim 1.

36. A complex of formula $ML_6Z$ suitable for use in the optical concentrator device specified in claim 1 which complex has the formula:
$M^1Y^1Y^2Y^3Z^2$, where $M^1$ is selected from Ru(II) and Os(II), $Z^2$ represents one or two anions having an overall negative charge of 2, and each of $Y^1$, $Y^2$ and $Y^3$ is independently selected from a structure containing a 2,2'-bipyridyl nucleus or a structure containing a 1,10-phenanthroline nucleus, at least one of $Y^1$, $Y^2$ and $Y^3$ carrying at least one substituent in the 2,2'--bipyridyl or 1, 10-phenanthroline nucleus provided that the substituent is other than deuterium and that where $Y^1$, $Y^2$ and $Y^3$ are identical and are 2,2'-bipyridyl structures the substituent if in the 4,4'-positions is other than methyl and phenyl and if in the 5,5'-positions is other than COOH, methyl, and COOR, where R is simple alkyl, and that where $Y^1$, $Y^2$ and $Y^3$ are identical and are 1,10-phenanthroline structures the substituent if in the 5 position is other than nitro, chloro, phenyl and methyl, if in the 4,7 positions is other than phenyl and methyl and if in the 5,6 positions is other than methyl and oxygen.

37. A complex as claimed in claim 36 and wherein at least two of $Y^1$, $Y^2$ and $Y^3$ are identical and at least one of $Y^1$, $Y^2$ and $Y^3$ is 2, 2'-bipyridyl having substituents in the 4,4'-positions.

38. A complex as claimed in claim 36 and wherein at least two of $Y^1$, $Y^2$ and $Y^3$ are identical and at least one of $Y^1$, $Y^2$ and $Y^3$ is 1,10-phenanthroline having substituents in the 4,7-positions.

39. A complex of the formula $ML_6Z$ suitable for use in the optical concentrator device specified in claim 1 which complex has the formula $M^2Y^4Y^5W^1W^2Z^3$, where $M^2$ is Ir(III), $Z^3$ represents an anion group, $W^1$ and $W^2$ are halogens and each of $Y^4$ and $Y^5$ is independently selected from an optionally substituted structure containing a 2,2'- bipyridyl or a 1,10-phenanthroline nucleus.

40. A complex as claimed in claim 39 and wherein at least one of $Y^4$ and $Y^5$ is a substituted 2,2'-bipyridyl structure carrying substituents in the 4,4'-positions.

41. A complex as claimed in claim 40 and wherein the substituents are aryl groups.

42. A complex as claim 39 and wherein at least one of $Y^4$ and $Y^5$ is a substituted 1,10-phenanthroline structure carrying substituents in the 4,7 positions.

43. A complex as claimed in claim 42 and wherein the substituents are aryl groups.

44. A complex as claimed in claim 36, 37 and 38 and wherein each of $Y^1$, $Y^2$ and $Y^3$ carries, in the 4 and 4' positions in the case where $Y^1$, $Y^2$ or $Y^3$ is a 2,2'-bipyridyl or in the 4 and 7 positions in the case where $Y^1$, $Y^2$ or $Y^3$ is a 1, 10-phenanthroline, a 3,4-disubstituted phenyl group in which the substituents in the 3- and 4- positions of the phenyl group are selected from optionally substituted alkyl and halo.

45. A complex as claimed in claim 44 and wherein the said substituents in the 3- and 4- positions of the said disubstituted phenyl groups are alkyl groups.

46. A complex as claimed in claim 45 and wherein the said alkyl groups are methyl groups.

47. A complex as claimed in claim 39 and wherein each of $Y^4$ and $Y^7$ carries in the 4 and4' positions in the case where $Y^4$ or $Y^5$ is 2,2'-bipyridyl or in the 4 and 7 positions in the case where $Y^4$ or $Y^5$ is 1, 10-phenanthroline a 3,4-disubstituted phenyl group in which the substituents in the 3- and 4- positions of the phenyl group are selected from optionally substituted alkyl and halo.

48. A complex as claimed in claim 36 or claim 39 and which is one of the specific complexes listed in Table 10 herein.

49. A device as claimed in claim 1 and wherein the complex of the formula $ML_6Z$ is a complex as claimed in any one of claims 44 to 47.

50. A composition as claimed in claim 22 and wherein the complex of the formula $ML_6Z$ is a complex as claimed in any one of claims 44 to 47.

0074807

1/6

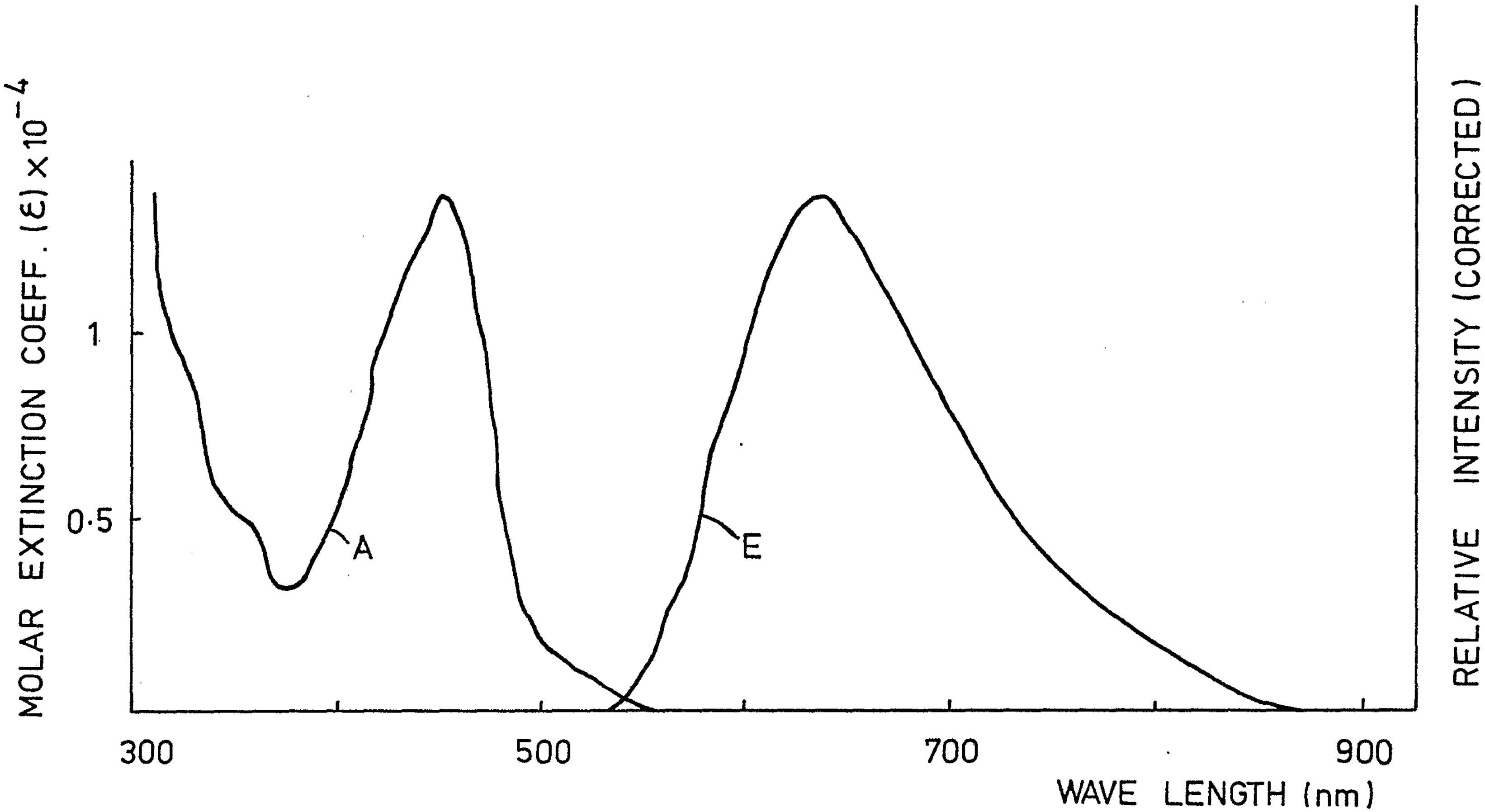


Fig.1.

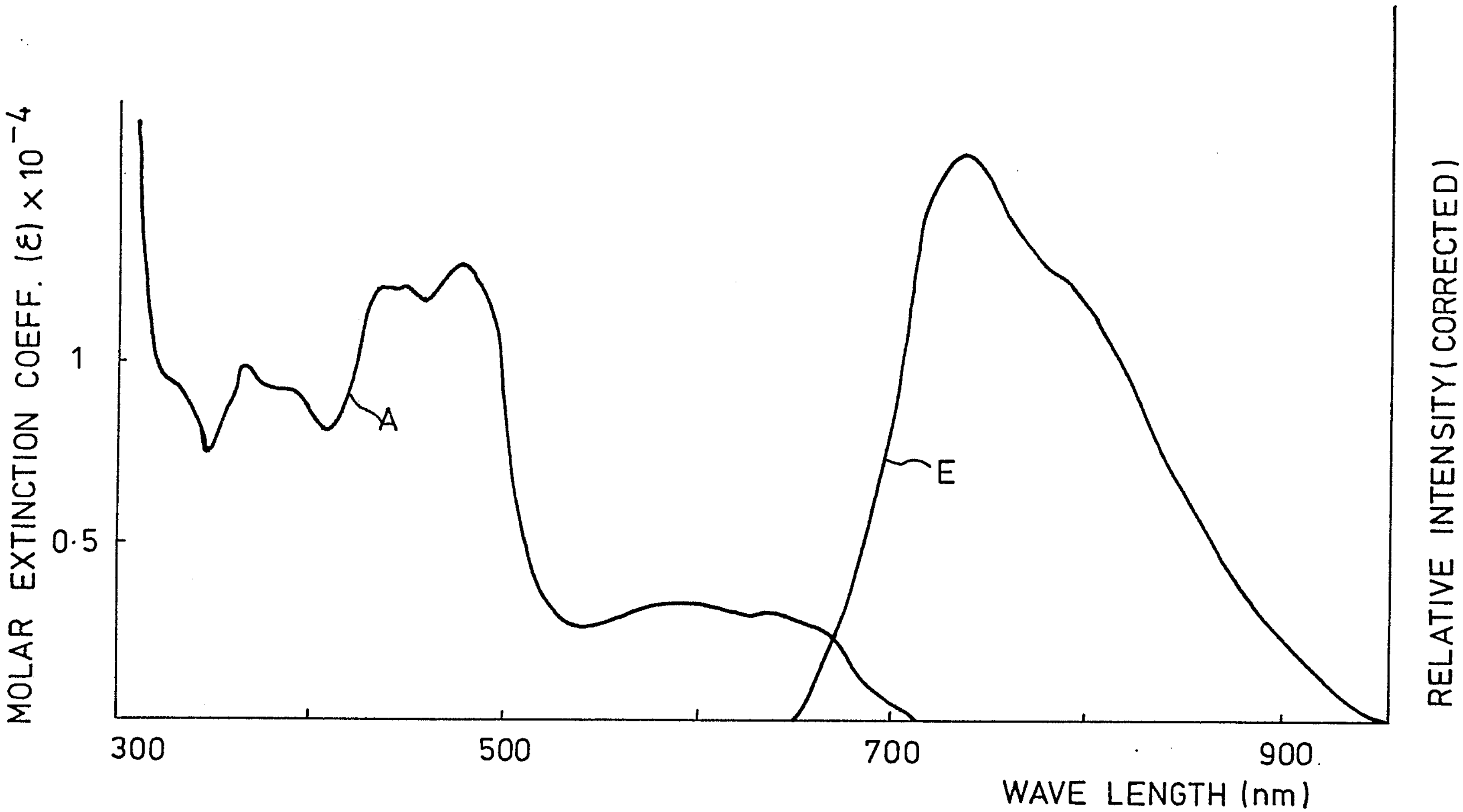
MOLAR EXTINCTION COEFF. (ε) × 10⁻⁴
1
0·5
A
E
300
500
700
900
WAVE LENGTH (nm)
RELATIVE INTENSITY (CORRECTED)

Fig. 2.

0074807

3/6

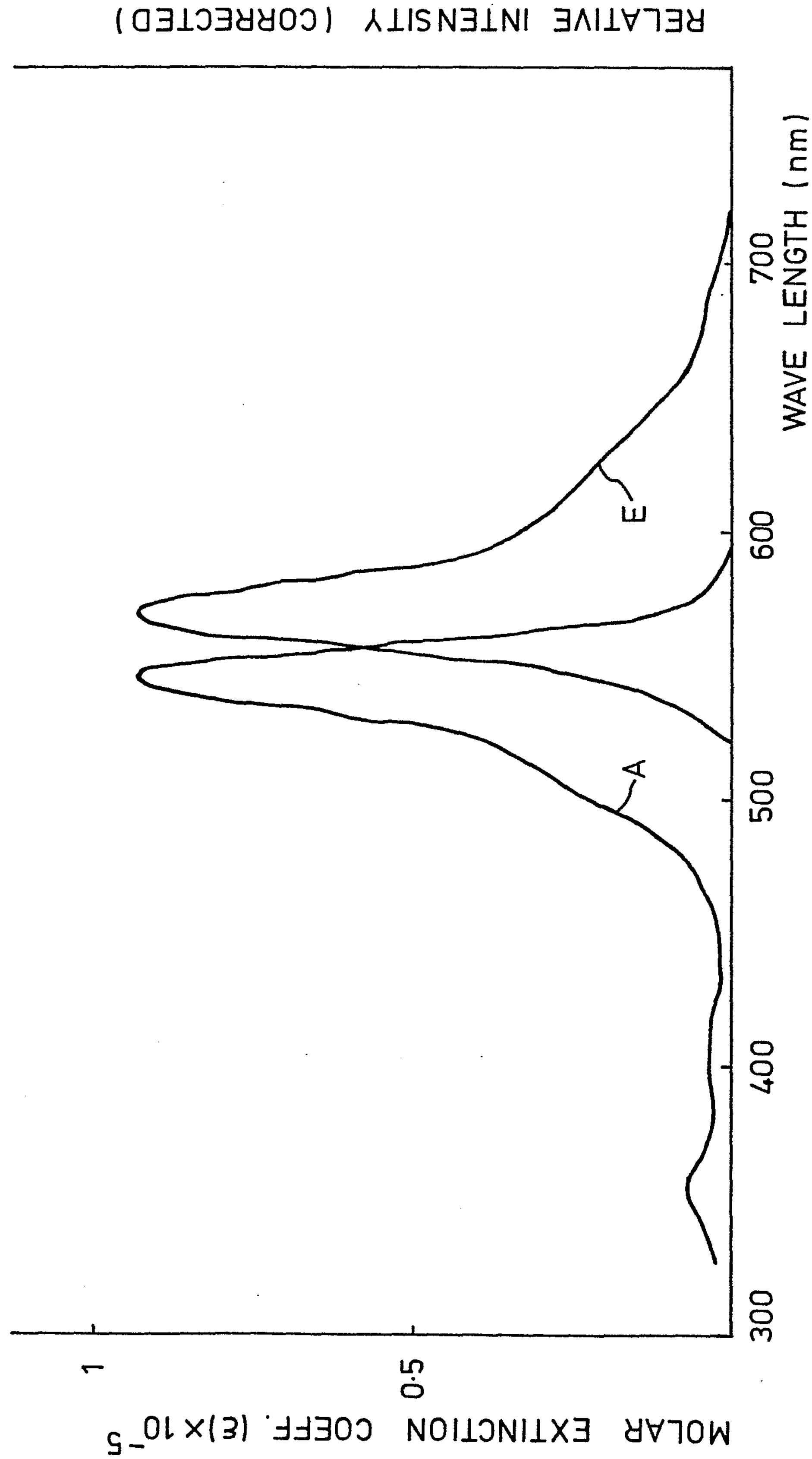


Fig. 3.

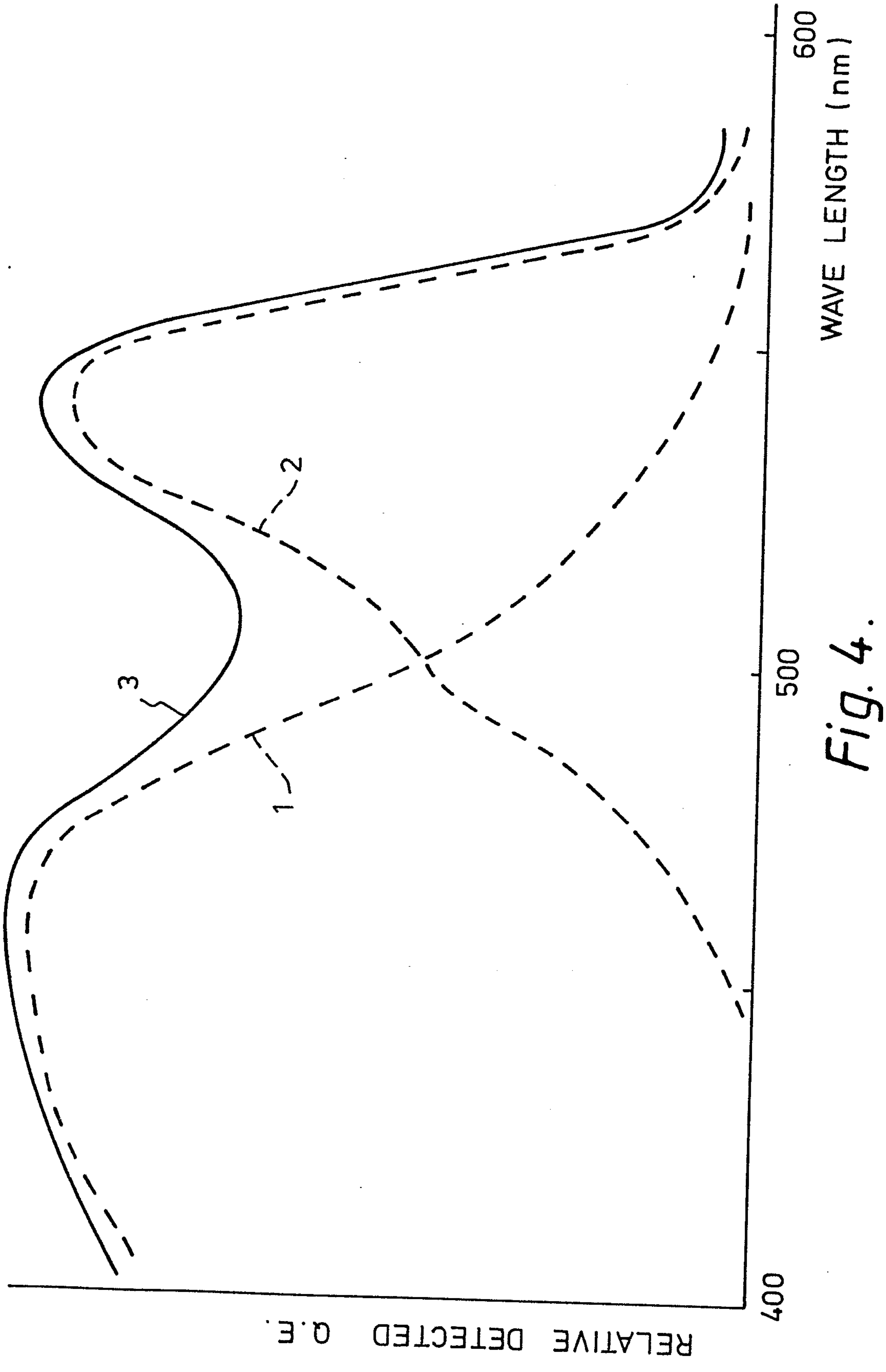


Fig. 4.

0074807

5/6

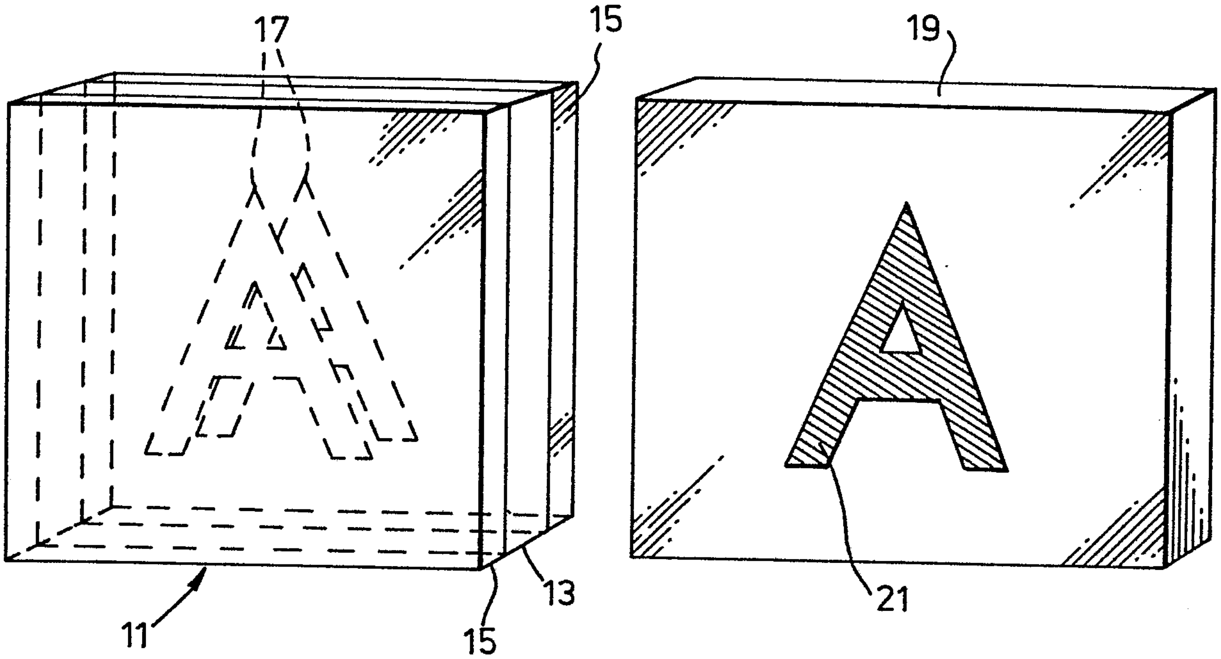


Fig. 5.

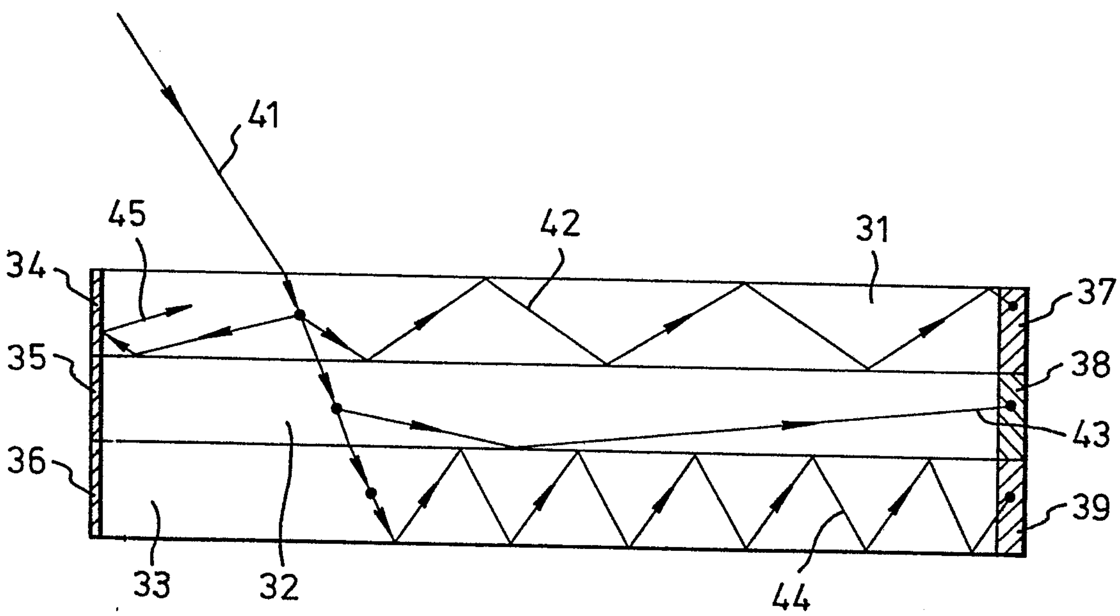


Fig. 6.

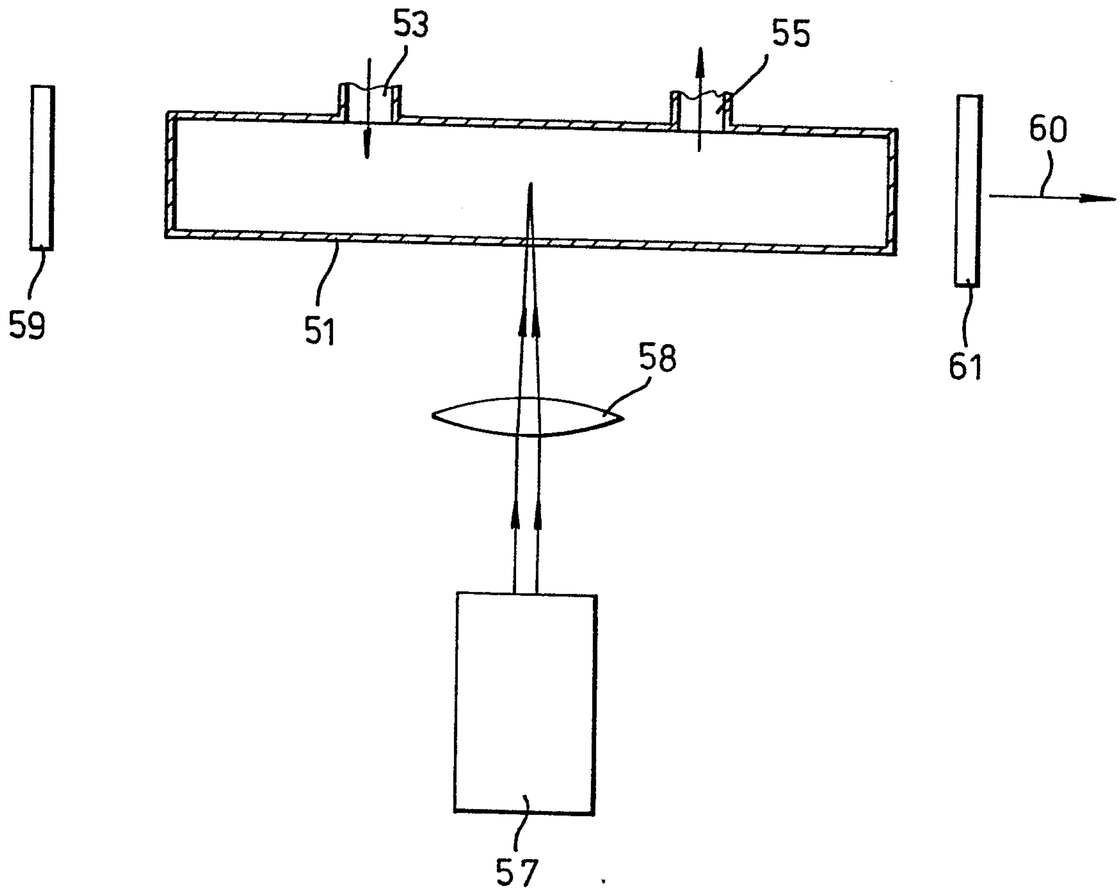


Fig. 7.

European Patent Office

# EUROPEAN SEARCH REPORT

0074807

Application number

EP 82304754.3

| Category | DOCUMENTS CONSIDERED TO BE RELEVANT<br>Citation of document with indication, where appropriate, of relevant passages | Relevant to claim | CLASSIFICATION OF THE APPLICATION (Int Cl 3) |
|---|---|---|---|
| A,D | US - A - 4 260 219 (GREUBEL)<br>* Fig. 1; column 3, line 65 - column 5, line 27 *<br>-- | 1,22,<br>31,34 | G 02 F 1/01<br>C 09 K 11/06<br>C 09 B 57/10<br>C 02 F 1/133<br>H 01 L 31/00<br>H 01 S 3/20 |
| A,D | OPTICS LETTERS, vol. 1, no. 2, August 1977<br>B.A. SWARTZ, T. COLE, A.H. ZEWAIL "Photon trapping and energy transfer in multipledye plastic matrices : an efficient solar-energy concentrator"<br>pages 73-75<br>* Complete *<br>-- | 22,31 | |
| A,D | APPLIED PHYSICS, vol. 14, no. 2, October 1977, Springer<br>A. GOETZBERGER, W. GREUBEL "Solon Engery Conversion with Fluorescent Collectors"<br>pages 123-139<br>* Page 123 - page 125; column 1, line 18; fig. 1,2,3; page 130, paragraph 3; page 138; Appendix *<br>-- | 31 | TECHNICAL FIELDS SEARCHED (Int Cl 3)<br>G 02 F 1/00<br>C 09 K 9/00<br>C 09 K 11/00<br>C 09 B 57/00<br>H 01 L 27/00<br>H 01 L 31/00<br>H 01 L 33/00<br>H 01 S 3/00<br>H 01 P 3/00 |
| A | GB - A - 2 003 290 (SECRETARY)<br>* Claims *<br>-- | 34 | |
| A,D | US - A - 4 271 395 (BRINKMANN)<br>* Column 1, lines 25-65; abstract *<br>-- | 35 | |

The present search report has been drawn up for all claims

| Place of search | Date of completion of the search | Examiner |
|---|---|---|
| VIENNA | 30-11-1982 | GRONAU |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82

European Patent Office

# EUROPEAN SEARCH REPORT

0074807
Application number

EP 82304754.3

| Category | DOCUMENTS CONSIDERED TO BE RELEVANT<br>Citation of document with indication, where appropriate, of relevant passages | Relevant to claim | CLASSIFICATION OF THE APPLICATION (Int. Cl. 3) |
|---|---|---|---|
| A | PATENT ABSTRACTS OF JAPAN, unexamined applications, section C, vol. 5, no. 49, April 8, 1981<br>THE PATENT OFFICE JAPANESE GOVERNMENT<br>page 125 C 49<br>* Kokai no. 56-4 680 (HITACHI) *<br>-- | | |
| A | PATENT ABSTRACTS OF JAPAN, unexamined applications, section C, vol. 3, no. 109, September 12, 1979<br>THE PATENT OFFICE JAPANESE GOVERNMENT<br>page 65 C 58<br>* Kokai no. 54-87 687 (DAINI) *<br>-- | | TECHNICAL FIELDS SEARCHED (Int. Cl. 3) |
| A,D | US - A - 4 111 534 (CIRKLER)<br>---- | | |

EPO Form 1503.2 06.78